# EUROPEAN PATENT APPLICATION

(11) **EP 4 621 838 A1**
(43) Date of publication of application: **24.09.2025**
(21) Application number: 25164231.0
(22) Date of filing: 17.03.2025
(51) Int. Cl.: H01L 21/762, H01L 21/764, H10D 84/01

(54) **TRANSISTOR ASSEMBLIES WITH PATTERNED BACK SIDE-FILLED ISOLATION REGIONS**

(30) Priority: 20.03.2024 US 202418610465
(71) Applicant: Intel Corporation, Santa Clara, CA 95054 (US)
(72) Inventor: LILAK, Aaron, Beaverton, 97007 (US); MANNEBACH, Ehren, Beaverton, 97007 (US); PHAN, Anh, Beaverton, 97007 (US); KEYS, Patrick, Beaverton, 14730 (US)
(74) Representative: 2SPL Patentanwälte PartG mbB

(57) **Abstract**

An integrated circuit (IC) device includes a first semiconductor region, a second semiconductor region, and a contact coupled to the first semiconductor region. The contact extends away from the semiconductor region in a direction. The IC device also includes an isolation region adjacent to the first semiconductor region and adjacent to the second semiconductor region. The isolation region includes a first isolation subregion and a second isolation subregion. A boundary between the first and second isolation subregions is substantially curved towards the direction.

## Description

### Background

Integrated circuit (IC) devices typically include a device layer in which transistors are formed. In certain designs, some transistors in the device layer are P-type metal-oxide-semiconductor (PMOS) transistors, and other transistors are N-type metal-oxide-semiconductor (NMOS) transistors. In some three-dimensional transistor architectures, channel regions may be formed along long semiconductor structures, such as fin-shaped or ribbon-shaped structures. These structures may be isolated by a fin trim isolation (FTI) process, which involves etching portions of the semiconductor structures to form individuated channel regions and filling the etched areas with a dielectric material; the same FTI dielectric material is typically used across the device layer. Transistors may be formed around the individuated channel regions.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIGs. 1A and 1B are schematic illustrations of cross-sectional views of an example transistor, according to some embodiments of the present disclosure.
FIG. 2 is a cross-sectional view through several transistors in an apparatus, according to some embodiments of the present disclosure.
FIG. 3A is a cross-sectional view of a portion of FIG. 2 along the plane C-C'.
FIG. 3B is a cross-sectional view of a portion of FIG. 2 along the plane D-D'.
FIGs. 3C and 3D are cross-sectional views of transistor assemblies with alternate backfilled isolation regions, according to various embodiments of the present disclosure.
FIG. 4 is a cross-sectional view of a transistor assembly with a cap over a back side-filled air gap, according to some embodiments of the present disclosure.
FIG. 5 is a flow diagram of an example process for manufacturing a transistor assembly with a back side-filled isolation region with an air gap, according to some embodiments of the present disclosure.
FIGs. 6A-6F are side, cross-sectional views of various stages of the example process of FIG. 5, according to some embodiments of the present disclosure.
FIG. 7 is a flow diagram of an example process for manufacturing a transistor assembly with a back side-filled isolation region with a fill material, according to some embodiments of the present disclosure.
FIGs. 8A and 8B are side, cross-sectional views of various stages of the example process of FIG. 7, according to some embodiments of the present disclosure.
FIGS. 9A and 9B are top views of a wafer and dies that include one or more transistor assemblies with back side-filled isolation regions in accordance with any of the embodiments disclosed herein.
FIG. 10 is a cross-sectional side view of an IC device that may include one or more transistor assemblies with back side-filled isolation regions in accordance with any of the embodiments disclosed herein.
FIG. 11 is a cross-sectional side view of an IC device assembly that may include one or more transistor assemblies with back side-filled isolation regions in accordance with any of the embodiments disclosed herein.
FIG. 12 is a block diagram of an example computing device that may include one or more transistor assemblies with back side-filled isolation regions in accordance with any of the embodiments disclosed herein.

### Detailed Description

The systems, methods, and devices of this disclosure each have several innovative aspects, no single one of which is solely responsible for all desirable attributes disclosed herein. Details of one or more implementations of the subject matter described in this specification are set forth in the description below and the accompanying drawings.

Transistor-based IC devices can include one or more device layers with transistors. The device layers may include isolation regions with isolation materials between different conductive components. The isolation materials can provide electrical isolation between different components of transistors in the device layer, e.g., between a gate and a source region. The isolation materials can also provide electrical isolation between different transistors, e.g., between gates of adjacent transistors.

For various transistors, such as fin-shaped field effect transistors (FinFETs), gate-all-around (GAA) transistors, and forksheet transistors, the isolation materials may be placed in regions between transistors. The isolation materials may be selected such that they function as strain materials, e.g., materials that can apply a tensile or compressive strain on a source region, a drain region, or a gated channel region.

For example, during fabrication of a FinFET, fin-shaped structures are formed from a semiconductor, e.g., by etching portions of a silicon wafer. The fin-shaped structures may be long regions that are then isolated by an FTI process, where the FTI process involves etching portions of the fin-shaped structures to form individuated fin structures. Transistors may be formed around the individuated fin structures. In particular, the fins form semiconductor channels, and a gate stack, a source region, and a drain region may be formed around each of the fin-shaped channels, realizing a FinFET. After individuating the channels for different transistors, a dielectric material may be deposited between adjacent channels to provide electrical isolation. In some cases, the dielectric material deposited between adjacent transistors (e.g., between adjacent fins or adjacent nanoribbon stacks of adjacent transistors) can be a dielectric material that can apply a particular type of stress or strain to adjacent materials, and in particular, to source and/or drain regions formed around the channels and on either side of the dielectric material. Using a dielectric material to apply strain (e.g., a strain material) can improve transistor performance, e.g., shifting the threshold voltage on the source and/or the drain, controlling the short-channel effect, and/or increasing a carrier mobility of a gated channel region.

A particular strain material may impart different effects on PMOS and NMOS devices (such as PMOS and NMOS transistors). For example, if a material that provides a tensile strain is adjacent to source and drain regions of both NMOS and PMOS devices, the PMOS performance may be improved, but the NMOS performance may be degraded. Conversely, if a material that provides a compressive strain is adjacent to source and drain regions of both NMOS and PMOS devices, the NMOS performance may be improved, but the PMOS performance may be degraded. Thus, when NMOS and PMOS devices are in a single layer (e.g., a device layer), using a single isolation material in fin trim isolation (FTI) regions (e.g., regions where dielectric material is provided between components, such as transistor components) provides non-ideal results, where some transistors have improved performance while others may be negatively affected.

In some cases, performance improvement in both NMOS and PMOS devices may be achieved by using different strain materials. For example, a first strain material that may provide a tensile strain may be placed adjacent to source and drain regions of a PMOS device to improve PMOS performance, and a second strain material that may provide a compressive strain may be placed adjacent to source and drain regions of an NMOS device to improve NMOS performance. Processes of providing different strain materials can involve multiple deposition processes with different materials (e.g., in isolation regions of a device layer), and lithography to block NMOS or PMOS devices during the deposition processes (e.g., involving processes of applying and removing a mask material). In some other cases, part or all of a first strain material (for example, a strain material that may provide a tensile strain) in a portion of the isolation regions of a device layer (e.g., isolation regions adjacent to NMOS devices) may be removed and replaced with a second strain material (for example, a strain material that may provide a compressive strain).

Conductive metal contacts are formed over the transistors in the device layer; for example, conductive contacts are coupled to gate stacks, source regions, and/or drain regions of transistors. These conductive contacts generally extend upwards from the transistors and towards a front side of the device layer to couple with conductive features of a front side metallization layer. Performing a deposition process to deposit different strain materials in different portions of the device layer (e.g., in isolation regions of the device layer adjacent to transistors or transistor components such as gate stacks, source regions, and/or drain regions), as noted above, can involve multiple deposition and etching processes with different materials, and lithography to block NMOS or PMOS devices during the deposition processes. Performing such processes from the front side of the device layer (i.e., on a side of the transistors including the conductive contacts) can be challenging. In cases where part or all of a first strain material is to be removed from an isolation region and replaced with a second strain material, the presence of the contacts on the front side of the device layer can lead to challenges during the removal and replacement. For example, the height of the contacts may make it difficult to precisely etch away a desired amount of the first strain material from an isolation region without damaging other structures, leading to less than desired tunability of stresses and strains in different isolation regions (e.g., for NMOS devices and PMOS devices).

As described herein, strain materials in isolation regions of a transistor assembly (e.g., on a device layer) can be selectively deposited from a back side of the device layer, such that performance improvement in both NMOS and PMOS transistor devices can be achieved with different isolation materials in NMOS and PMOS regions. In an example process, a device layer can be formed over a substrate, the device layer including semiconductor regions (e.g., including transistors such as FinFETs with fin-shaped channel regions, or GAA transistors with nanoribbon or nanowire channels). The device layer can also include isolation regions adjacent to the semiconductor regions (e.g., between source or drain regions of adjacent transistors) that are filled with a first isolation material (e.g., a strain material which can provide a tensile strain to improve PMOS device performance). After forming a front side metallization stack over the device layer, the device may be flipped, and the back side of the device layer may be exposed.

Over the back side of the device layer, a first subset of the isolation regions is masked with a mask material (e.g., forming a pattern of mask material over the back side of the device layer), and a second subset of the isolation regions is exposed. The isolation regions of the second subset are etched to form cavities in the isolation regions (e.g., patterning of the back side of the device layer, where isolation regions in the first subset are not etched, and isolation regions in the second subset are etched), where the etching process is controlled to obtain cavities of a desired size or shape. The cavities are filled with a second isolation material (e.g., a strain material which can provide a compressive strain to improve NMOS device performance). In other words, an isolation region of the second subset includes a first isolation subregion including the first isolation material, and a second isolation subregion including the second isolation material. A boundary between the first and second isolation subregions may be substantially curved towards the front side metallization layer, i.e., in the direction of transistor contacts extending away from the transistors and towards the front side metallization layer.

In some embodiments, the second isolation material includes a solid material including oxygen or nitrogen. In some embodiments, the second isolation material includes air (e.g., an air gap may be in isolation regions of the second subset), and the isolation region may be capped (e.g., with a dielectric cap material) to prevent the air gap from being filled. In some embodiments, the second isolation material includes a cavity or a void (for example, including air or another gas). The selection of the second isolation material, along with the selection of the size and shape of the cavity, can allow for a high degree of tunability of stresses on NMOS and PMOS devices. Performing the masking, etching, and filling processes over the back side of the device layer can help minimize or eliminate potential issues associated with performing processes over the front side of the device layer as described above.

In the following, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because, as is common in the field of transistors, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metallization layer" may refer to a layer on a side of a support structure that includes electrically conductive interconnect structures for providing electrical connectivity between different IC components. Metallization layers described herein may also be referred to as "interconnect layers" to clearly indicate that these layers include electrically conductive interconnect structures which may include but do not have to include metal.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. As used herein, a "logic state" (or, alternatively, a "state" or a "bit" value) of a memory cell may refer to one of a finite number of states that the cell can have, e.g., logic states "1" and "0," each state represented by a different voltage of the capacitor of the cell, while "READ" and "WRITE" memory access or operations refer to, respectively, determining/sensing a logic state of a memory cell and programming/setting a logic state of a memory cell. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

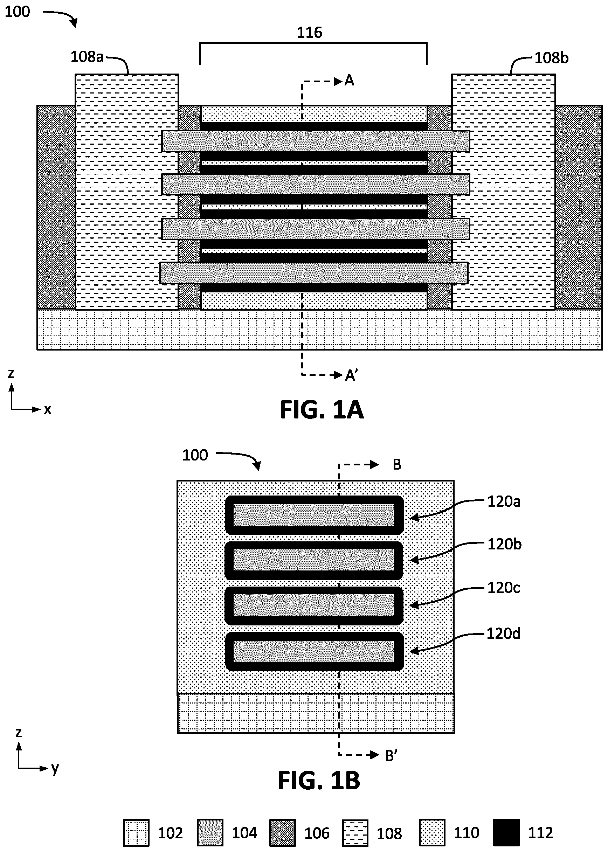

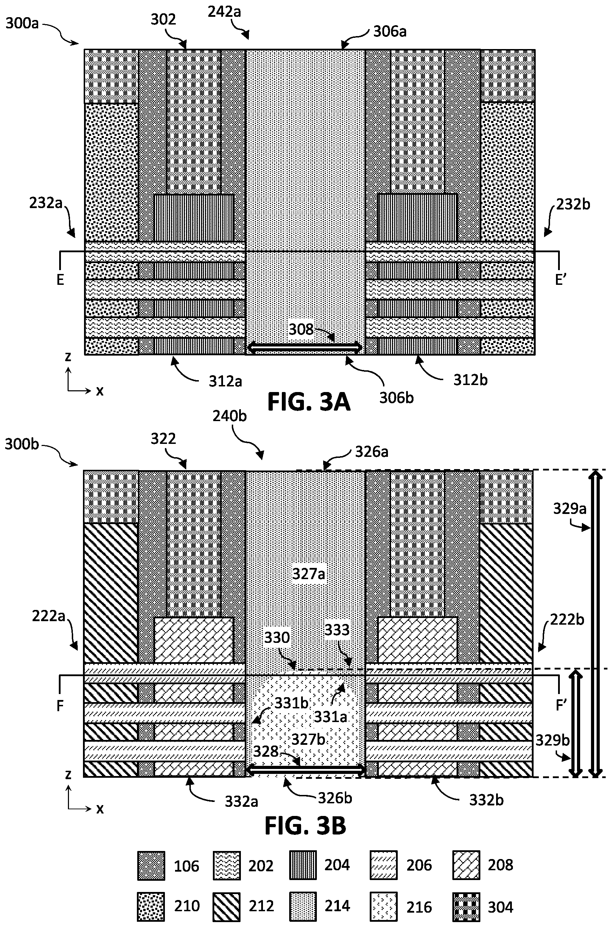

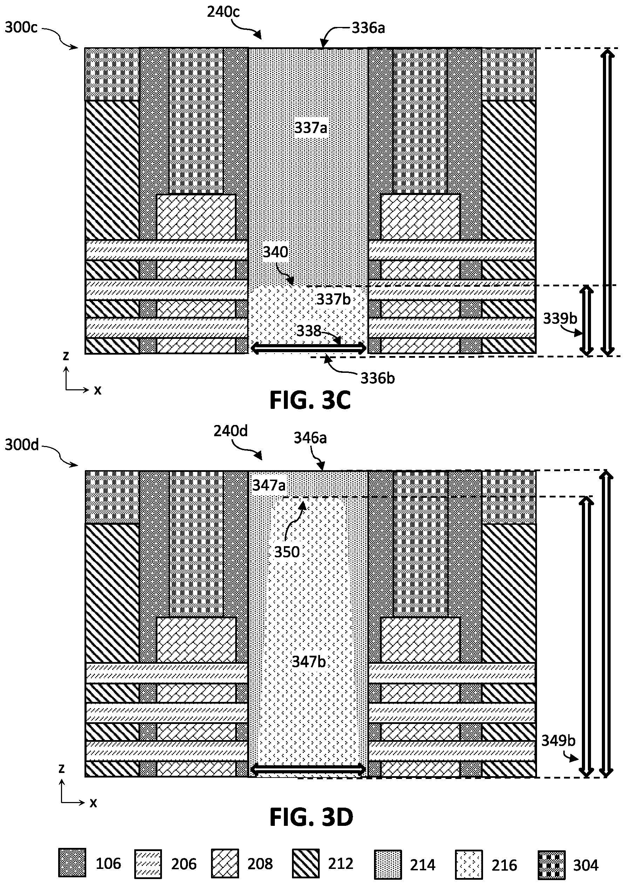

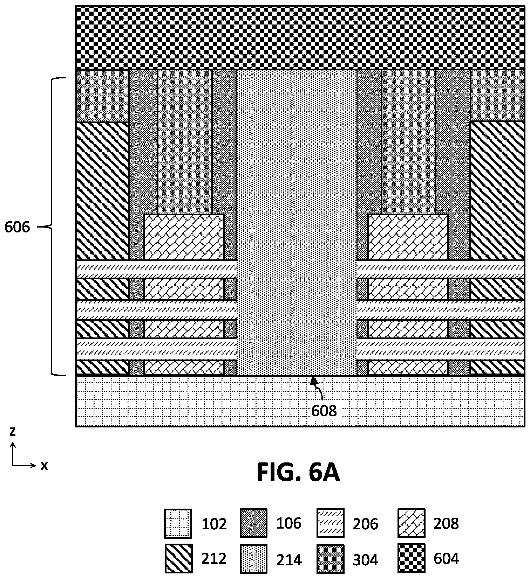

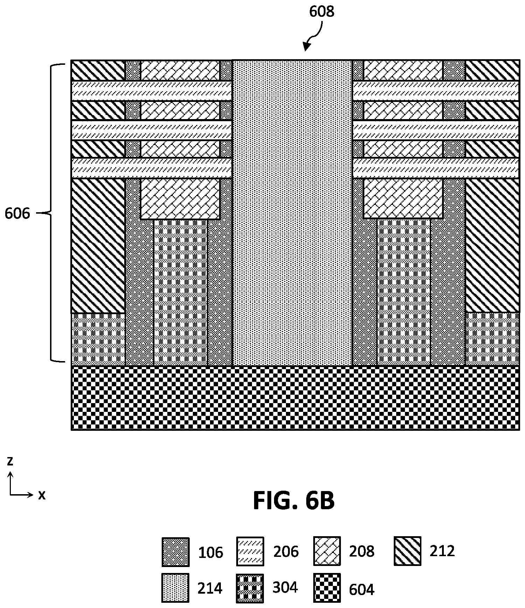

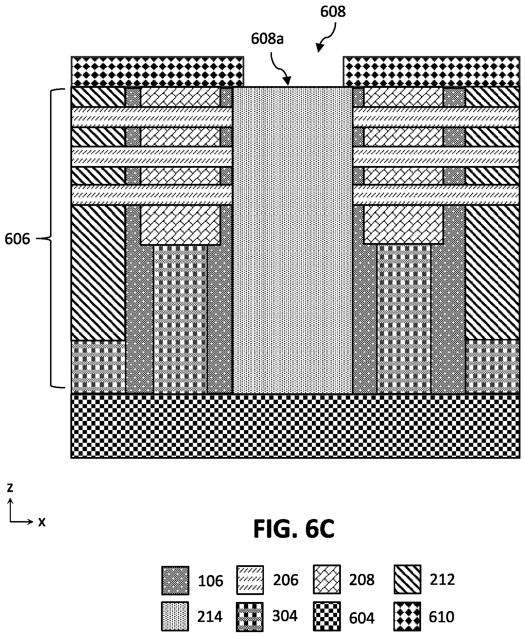

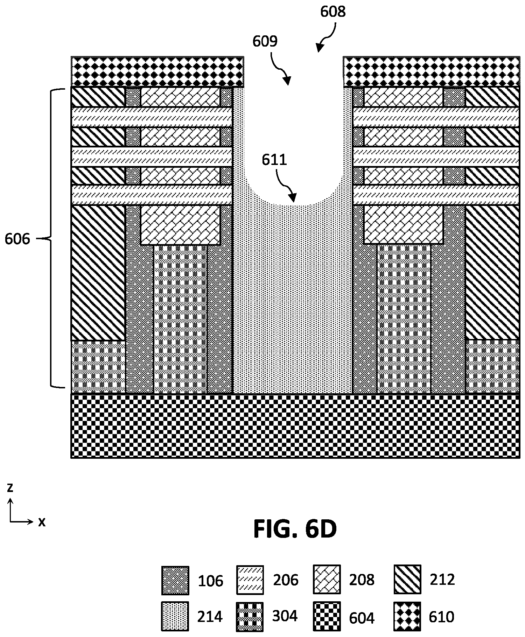

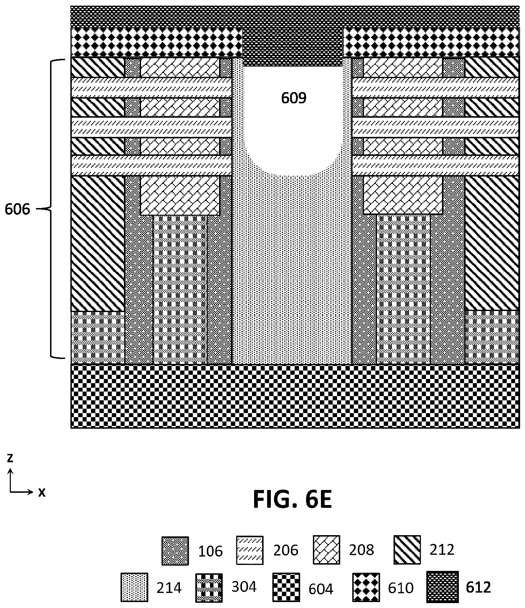

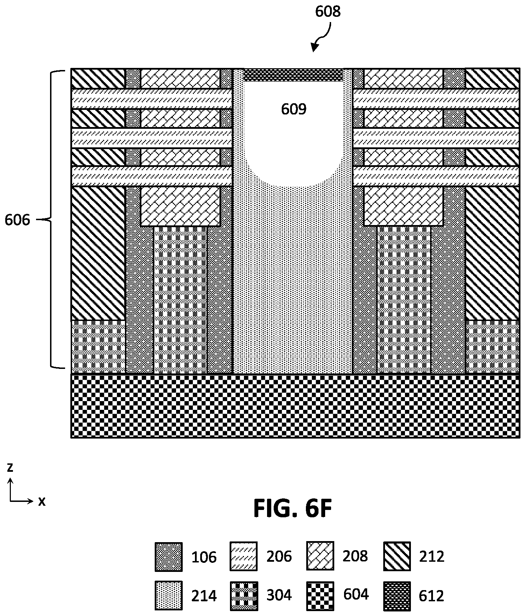

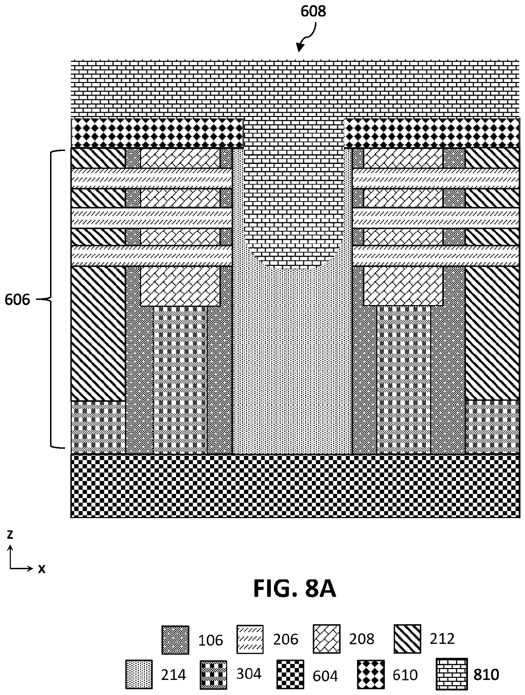

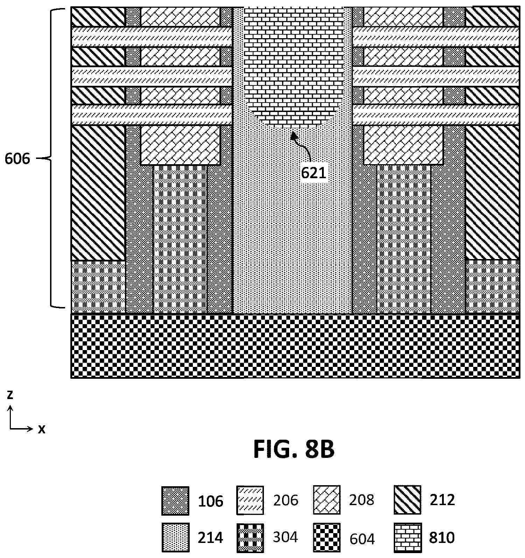

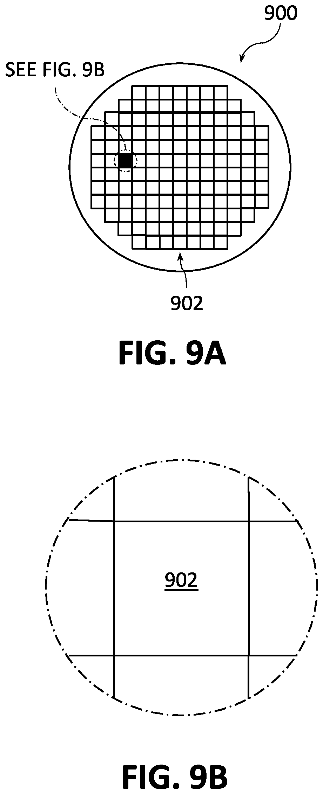

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, the phrase "FIG 1" may be used to refer to the collection of drawings of FIGS. 1A-1B, the phrase "FIG. 3" may be used to refer to the collection of drawings of FIG. 3A-3D, the phrase "FIG. 6" may be used to refer to the collection of drawings of FIGS. 6A-6F, the phrase "FIG. 8" may be used to refer to the collection of drawings of FIGS. 8A-8B, the phrase "FIG. 9" may be used to refer to the collection of drawings FIG. 9A-9B, etc.

In the drawings, some example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects or features could also be visible, e.g., not-perfectly straight edges of materials, tapered vias or other openings, rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices or electronic devices with transistor assemblies as described herein (e.g., having back side-filled isolation regions) may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

FIGs. 1A-1B illustrate an example architecture of a nanoribbon-based transistor. FIG. 1A is a cross-section across a transistor 100 showing a channel, a source, a gate region, and a drain. FIG. 1B is a cross-section across the gate region of the transistor 100. FIG. 1B is a cross-section through the plane A-A' in FIG. 1A, and FIG. 1A is a cross-section through the plane B-B' in FIG. 1B.

A number of elements are referred to in descriptions of FIGs. 1A-1B, 2, 3A-3D, 4, 6A-6F, and 8A-8B with reference numerals which correspond to different patterns illustrated in the figures, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) region 108, a gate electrode 110, and a gate dielectric 112.

In general, implementations of the present disclosure may be formed or carried out on a support structure, e.g., the support structure 102 illustrated in FIG. 1. The support structure 102 may be, e.g., a substrate, a die, a wafer or a chip. For example, the support structure 102 may be the wafer 900 of FIG. 9A, discussed below, and may be, or be included in, a die, e.g., the singulated die 902 of FIG. 9B, discussed below. The support structure 102 extends along the x-y plane in the coordinate system shown in FIG. 1. In some embodiments, a support structure 102 may be used during a fabrication process and later removed. For example, a top side (e.g., front side) of the transistor 100 may be attached to a second support structure (e.g., a second one of the support structures 102, which may be referred to as a carrier structure), and the support structure 102 over which the transistor 100 is formed may be removed to expose a bottom side (e.g., back side) of the transistor 100.

In some embodiments, the support structure 102 may be a substrate that includes silicon and/or hafnium. More generally, the support structure 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the support structure 102 may be non-crystalline. In some embodiments, the support structure 102 may be a printed circuit board (PCB) substrate. Although a few examples of materials from which the support structure 102 may be formed are described here, any material that may serve as a foundation upon which a semiconductor device as described herein (e.g., a semiconductor device including one or more fin-shaped field effect transistors, nanoribbon transistors, or nanowire transistors) may be built falls within the spirit and scope of the present disclosure.

In FIGs. 1A and 1B, the transistor 100 is formed over the support structure 102. The transistor 100 includes a channel material 104 formed into four nanoribbons stacked on top of each other. In other examples, the transistor 100 may include more or fewer nanoribbons, e.g., one, two, three, five, six or more nanoribbons. The channel material 104 may be a semiconductor, and may include silicon or other semiconductor materials described herein.

The transistor 100 includes nanoribbons 120a, 120b, 120c, and 120d, referred to collectively as nanoribbons 120 or nanoribbon channels, or individually as a nanoribbon 120 or nanoribbon channel. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the smallest distance from the support structure 102. S/D regions 108a and 108b are formed at either end of the nanoribbon channels 120, as illustrated in FIG. 1A.

In general, to form nanoribbon channels such as the nanoribbon channels 120, alternating layers of the channel material 104 and a sacrificial material are deposited over the support structure 102. The sacrificial material is removed from the stack and replaced with other material, e.g., material for forming a gate stack 116, so the sacrificial material is not shown in FIG. 1. The channel material 104 and sacrificial materials include different materials. In one example, the channel material 104 is silicon, while the sacrificial material includes silicon and germanium. The sacrificial material may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material (or substantially monocrystalline layers) may be formed over each other. In different embodiments, the channel material 104 and/or the sacrificial material may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both NMOS transistors and PMOS transistors, e.g., alternating rows of NMOS and PMOS transistors. NMOS and PMOS transistors can use different groups of channel material 104, e.g., silicon may be used to form an N-type semiconductor channel, while silicon germanium may be used to form a P-type semiconductor channel. In some embodiments, a single channel material 104 is used (e.g., silicon), and different portions (e.g., channel material to form different transistors) may include different dopants, e.g., N-type dopants for NMOS transistors and P-type dopants for PMOS transistors.

The S/D regions 108 may be formed from one or more layers of doped semiconductors, metals, metal alloys, or other materials. In some embodiments described herein, the S/D regions 108 may include a doped semiconductor, such as silicon or another semiconductor doped with an N-type dopant or a P-type dopant. In some embodiments, the S/D regions 108 may include multiple layers with different levels of conductivity, e.g., a doped semiconductor followed by a more highly doped semiconductor, or a semiconductor followed by metal.

A portion (e.g., a central portion) of each of the nanoribbon channels 120 is surrounded by a gate stack 116, which in this example, includes a gate electrode 110 and gate dielectric 112. Nanoribbon transistors often include a gate dielectric 112 that surrounds the nanoribbon channels 120, and a gate electrode 110 that surrounds the gate dielectric 112. While not specifically shown, in some embodiments, the gate dielectric 112 around each nanoribbon channel 120 includes multiple layers, e.g., an oxide layer and a high-k dielectric layer. The oxide layer may be grown directly on the nanoribbon channels 120, and the high-k dielectric may surround the oxide. The oxide may include oxygen in combination with the channel material 104. For example, if the nanoribbon channels are formed from silicon, the gate dielectric 112 may include a layer of silicon oxide. The high-k dielectric may be formed over the oxide. The gate electrode 110 surrounds the gate dielectric 112, e.g., the high-k dielectric (if included). In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

In various embodiments, the gate dielectric 112 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, the gate dielectric 112 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D regions 108 are filled in with a dielectric material 106. In the region between the gate stack 116 and the S/D regions 108, the dielectric material 106 forms a series of cavity spacers. Cavity spacers, also referred to as "dimple spacers" or "inner spacers," provide electrical isolation between the S/D regions 108 formed at the ends of the nanoribbons 120 and the gate electrode 110 deposited around the nanoribbons 120.

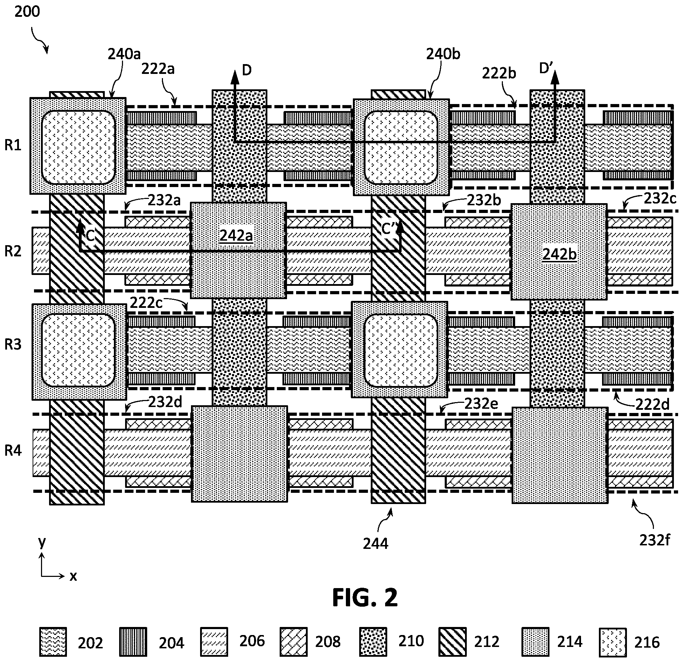

FIG. 1 illustrates a single nanoribbon transistor 100. In IC devices, many similar or identical transistors are arranged within a device layer (e.g., in a transistor assembly in a device layer). The dielectric material 106 and/or different materials may provide isolation between different transistors, or between other conductive materials in or near the device layer. As described with respect to FIGs. 2-8, certain portions of a first isolation material within a transistor layer may be removed and replaced (e.g., from a back side of a device layer) with a second isolation material (e.g., air or a solid isolation material), which can allow for one or more of the benefits or advantages described above to be realized.

FIG. 2 illustrates a cross-section through several transistors (e.g., through a transistor assembly) in an apparatus 200 (e.g., in an IC device, or in a device layer of an electronic device), according to some embodiments of the present disclosure. A legend at the bottom of FIG. 2 illustrates that FIG. 2 uses different patterns to show a first channel material 202, a first S/D material 204, a second channel material 206, a second S/D material 208, a first gate material 210, a second gate material 212, a first isolation material 214, and a second isolation material 216.

The cross-section illustrated in FIG. 2 includes first transistors, such as first transistors 222a, 222b, 222c, 222d (referred to jointly as first transistors 222) and second transistors, such as second transistors 232a, 232b, 232c, 232d, 232e, 232f (referred to jointly as second transistors 232), as outlined in dotted line segments. Some of the transistors (such as second transistors 232a, 232c, 232d, 232f) are only partially shown in FIG. 2. The first and second transistors 222, 232 may include different types of transistors. For example, the first transistors 222 may be PMOS transistors (e.g., comprising a PMOS type dopant), and the second transistors 232 may be NMOS transistors (e.g., comprising a NMOS type dopant). Alternatively, the first transistors 222 may be NMOS transistors, and the second transistors 232 may be PMOS transistors. In some embodiments, the first and second transistors 222, 232 may include FinFETs, GAA transistors, or forksheet transistors. The first and second transistors may include nanowires, nanosheets, or nanoribbons, such as the nanoribbon-based transistor shown in FIG 1. As shown, the first and second transistors 222, 232 may be in different rows (e.g., four rows designated R1, R2, R3, R4), where the rows R1 and R3 include the first transistors 222a, 222b, 222c, 222d and the rows R2 and R4 include the second transistors 232a, 232b, 232c, 232d, 232e, 232f. The materials used within the first transistors 222 and the second transistors 232 may be different. For example, the first transistors 222 may include the first channel material 202, first S/D material 204, and first gate material 210, which may be selected from the materials used for PMOS transistors described with respect to FIG. 1. The second transistors 232 may include the second channel material 206, second S/D material 208, and second gate material 212, which may be selected from the materials used for NMOS transistors described with respect to FIG. 1. While four rows R1, R2, R3, R4 of transistors are shown in FIG. 2, other rows of transistors may be present. While a certain number of transistors or parts thereof is illustrated in FIG. 2, in other embodiments, a different number of transistors (e.g., first transistors 222 and second transistors 232) may be included in the apparatus 200.

In FIG. 2, first isolation regions 240 (e.g., the isolation regions 240a and 240b) and second isolation regions 242 (e.g., the isolation regions 242a and 242b) are adjacent to the transistors. The first isolation regions 240 are between pairs of the first transistors 222 (for example, the isolation region 240b is between the first transistors 222a and 222b). The second isolation regions 242 are between pairs of the second transistors 232 (for example, the isolation region 242a is between the second transistors 232a and 232b, and the isolation region 242b is between the second transistors 232b and 232c). Isolation regions may be along a gate line. For example, in FIG. 2, a first isolation region 240b is adjacent to first transistors 222a, 222b in row R1, and the first isolation region 240b is along the gate line 244, which is the gate line of the second transistor 232b in row R2.

Different isolation materials may be included in the isolation regions. As shown in FIG. 2, the first isolation regions 240 include both the first isolation material 214 and the second isolation material 216, and the second isolation regions 242 include the first isolation material 214. One or more intermediary materials or liners (not shown) may be between the first isolation material 214 and the second isolation material 216 in the first isolation regions 240.

The first isolation regions 240 (including the second isolation material 216) impart a first type of strain on at least portions of adjacent first transistors 222 (for example, S/D regions or channels of the first transistors 222), while the second isolation regions 242 (including the first isolation material 214) impart a second type of strain on at least portions of adjacent second transistors 232 (e.g., S/D regions or channels of the transistors 232). For example, if the second transistors 232 are NMOS transistors, the first isolation material 214 may be a compressive material (e.g., a material that compresses or shrinks, e.g., during a deposition or annealing process), and may impart a tensile strain on the adjacent second transistors 232. In this example, the first transistors 222 are PMOS transistors, and the second isolation material 216 of the first isolation regions 240 may be a tensile material (a material that expands, e.g., during a deposition or annealing process). Introducing the second isolation material 216 changes the strain qualities of the first isolation regions 240, e.g., reducing the tensile strain and/or increasing the compressive strain on the adjacent first transistors 222 compared to an isolation region that only includes the first isolation material 214. The relative quantities and configurations of the first isolation material 214 and the second isolation material 216 of the first isolation regions 240 may be selected or tuned in order to provide a desired degree of compressive force or strain on the adjacent first transistors 222.

As another example, if the first transistors 222 are NMOS transistors and the second transistors 232 are PMOS transistors, the first isolation material 214 may be a tensile material selected to provide a compressive force on the adjacent second transistors 232 from the second isolation regions 242, while the second isolation material 216 within the first isolation regions 240 may be a compressive material selected to provide a tensile strain on the adjacent first transistors 222. Again, the quantities and configurations of the first isolation material 214 and the second isolation material 216 within the first isolation regions 240 may be selected or tuned in order to provide a desired degree of tensile strain on adjacent first transistors 222.

The first isolation material 214 and the second isolation material 216 may include different dielectric materials, such as oxides (e.g., aluminum oxide, hafnium oxide, silicon oxide, etc.) or nitrides (e.g., silicon nitride). For example, the first isolation material 214 may include an oxide, and the second isolation material 216 may include a nitride. In some embodiments, the second isolation material 216 may include air (e.g., the second isolation material 216 may be an air gap). In some embodiments, the second isolation material 216 may include a cavity or a void (e.g., including air or another gas). The first isolation material 214 may have a different material composition from the second isolation material 216. For example, with regards to an isolation material imparting a first type of strain (e.g., a compressive strain) on at least a portion of a PMOS transistor, the isolation material may include nitrogen (e.g., silicon nitride or another nitride), and with regards to an isolation material imparting a second type of strain (e.g., a tensile strain) on at least a portion of an NMOS transistor, the isolation material may include oxygen (e.g., an oxide). Alternatively, or in addition, a fabrication process for the first isolation material 214 may be different from a fabrication process for the second isolation material 216. For example, different annealing temperatures may provide different densities, where the strain type is based on the density of the isolation material. As another example, to increase the density of an isolation material, an implantation process may be performed in an isolation region, e.g., to implant boron or another material into the isolation material. Differing the densities in the first isolation material 214 and in the second isolation material 216 (by selection of materials having different densities, or by fabricating or processing the first isolation material 214 and the second isolation material 216 differently, as described above) can aid in tuning the types of strain that can be provided by the first and second isolation materials 214, 216. In some embodiments, the first isolation material 214 may have a greater density than the second isolation material 216, or the second isolation material 216 may have a greater density than the first isolation material 214.

FIG. 3A shows a cross-sectional view of a portion of FIG. 2 along the plane C-C', according to some embodiments of the present disclosure. FIG. 3B is a cross-sectional view of a portion of FIG. 2 along the plane D-D', according to some embodiments of the present disclosure. The cross-sectional view of FIG. 2 is along the plane E-E' shown in FIG. 3A, and along the plane F-F' shown in FIG. 3B. A legend at the bottom of FIG. 3B illustrates that FIG. 3A and FIG. 3B use different patterns to show the dielectric material 106, the first channel material 202, the first S/D material 204, the second channel material 206, the second S/D material 208, the first gate material 210, the second gate material 212, the first isolation material 214, the second isolation material 216, and a contact material 304.

FIG. 3A illustrates a transistor assembly 300a including portions of the second transistors 232a and 232b shown in FIG. 2. FIG. 3A includes the first channel material 202 (in the form of nanoribbons), first S/D material 204, and first gate material 210. The dielectric material 106 may be around the second transistors 232a, 232b (e.g., adjacent to the first channel material 202, first S/D material 204, and the first gate material 210). While a single dielectric material 106 is illustrated, different dielectric materials may be used at different parts of the transistor assembly 300a, e.g., any of the dielectric materials described above. Contacts 302 extend away from the first S/D material 204 and first gate material 210 (e.g., towards a top or front side of the transistor assembly 300a, in an upward direction along the z-axis as shown in FIG. 3A). The contacts 302 are formed from the contact material 304, which is a conductive material, such as a metal. The contacts 302 shown in FIG. 3A may conduct electrical signals to or from the first S/D material 204 and/or the first gate material 210 (e.g., to or from a front side metallization layer over the transistor assembly 300a as described below).

The second isolation region 242a, which includes the first isolation material 214, is between the second transistors 232a, 232b. In some embodiments, during fabrication, the first isolation material 214 may be deposited into the second isolation region 242a from a front side of the transistor assembly 300a. In some embodiments, during fabrication, the first isolation material 214 may be deposited into the second isolation region 242a from a back side of the transistor assembly 300a. The second isolation region 242a is adjacent to a first semiconductor region (e.g., an S/D region 312a of the second transistor 232a) and adjacent to a second semiconductor region (e.g., an S/D region 312b of the second transistor 232b). In other words, the second isolation region 242a is between two S/D regions 312a and 312b. In the illustration, portions of the dielectric material 106 are between the second isolation region 242a and the S/D regions 312a and 312b adjacent to the second isolation region 242a; in other examples, the second isolation region 242a directly abuts one or both of the S/D regions 312a and 312b. The second isolation region 242a can impart a first kind of strain on the first and second S/D regions 312a and 312b as described above.

As shown in FIG. 3A, the second isolation region 242a has a first end 306a (e.g., at the top or front side of the transistor assembly 300a) and a second end 306b (e.g., at the bottom or back side of the transistor assembly 300a). The second end 306b is substantially opposed to the first end 306a. The second isolation region 242a, including the second end 306b, has a width 308 along the x-axis in the coordinate system shown. The first isolation material 214 extends along the width 308.

FIG. 3B illustrates a transistor assembly 300b including portions of the first transistors 222a and 222b shown in FIG. 2. FIG. 3B includes the second channel material 206, second S/D material 208, and second gate material 212. Similar to FIG. 3A above, dielectric material 106 may be around the first transistors 222a and 222b (e.g., adjacent to the second channel material 206, second S/D material 208, and the second gate material 212), and contacts 322 formed from contact material 304 extend away from the second S/D material 208 and second gate material 212 (e.g., towards a top or front side of the transistor assembly 300b, and upwardly along the z-axis as shown in FIG. 3B). The contacts 322 shown in FIG. 3B may conduct electrical signals to or from the second S/D material 208 and/or the second gate material 212 (e.g., to or from a front side metallization layer over the contacts 322).

As shown in FIG. 3B, the first isolation region 240b is between the first transistors 222a, 222b. The first isolation region 240b is between a first semiconductor region (e.g., an S/D region 332a of the first transistor 222a) and a second semiconductor region (e.g., an S/D region 332b of the first transistor 222b). In other words, the first isolation region 240b is adjacent to the two S/D regions 332a and 332b. In the illustration, portions of the dielectric material 106 are between the first isolation region 240b and the S/D regions 332a and 332b adjacent to the first isolation region 240b; in other examples, the first isolation region 240b directly abuts one or both of the S/D regions 332a and 332b.

The first isolation region 240b includes a first end 326a (e.g., a top end, a front end, or a front side end) and a second end 326b (e.g., a bottom end, a back end, or a back side end). The second end 326b is substantially opposed to the first end 326a. The first isolation region 240b, including the second end 326b, has a width 328 along the x-axis in the coordinate system shown.

The first isolation region 240b includes a first isolation subregion 327a including the first isolation material 214 and a second isolation subregion 327b including the second isolation material 216. A boundary 330 (e.g., border) is between the first isolation subregion 327a and the second isolation subregion 327b. The first isolation subregion 327a extends to a first height 329a (e.g., a first distance along the z-axis shown in FIG. 3B or a first distance between the second end 326b and the first end 326a). The second isolation subregion 327b extends to a second height 329b (e.g., a second distance along the z-axis, or a second distance between the second end 326b and the first end 326a). As shown in FIG. 3B, the second height 329b is less than the first height 329a.

As shown in FIG. 3B, the boundary 330 includes a first portion 331a, which has a curved shape (e.g., curved portion; such as a curved shape of a semi-circle or semi-ellipse, as viewed along a plane parallel to the z-direction). The first portion 331a of the boundary 330 may be curved towards the first end 326a of the first isolation region 240b (e.g., upwardly along the z-axis, or substantially towards the same direction along which the contacts 322 extend away from the second S/D material 208 and second gate material 212). The first portion 331a may be curved upwardly as a result of the second isolation subregion 327b having been filled with the second isolation material 216 from a back side of the transistor assembly 300b (which may be referred to as a transistor assembly with a back side-filled isolation region) as described in further detail below. A first part of the first portion 331a (for example, a central portion or a curve apex of the first portion 331a, where a plane tangent to the curve apex and perpendicular to the z-axis may be along dotted line 333 in FIG. 3B, and may be at the second height 329b) may extend further along the z-axis (i.e., further from the second end 326b) than a second part of the first portion 331a (for example, an edge portion or a portion outside of the curve apex of the first portion 331a).

The boundary 330 may also have a second portion 331b (e.g., a side portion). As shown in FIG. 3B, the second portion 331b of the boundary 330 is outside of the first portion 331a of the boundary 330, and the second portion 331b is located such that a portion of the first isolation material 214 is between each of the first and second S/D regions 332 and the second isolation material 216.

The second height 329b of the second isolation subregion 327b (e.g., at a curve apex of the first portion 331a of the boundary 330) may be level with, above, or below a height of at least a portion of the S/D regions 332 or other structures in the transistors 222, e.g., the second channel material 206. For example, as shown in FIG. 3B, the second height 329b may be level with a height of a portion of the second channel material 206 (such as one of the nanoribbons of second channel material 206). As another example, the S/D region 332a may extend (e.g., along the z-axis) between a first S/D region height and a second S/D region height, and the second height 329b may be between the first S/D region height and the second S/D region height. In other embodiments, the second height 329b may be outside of a range bounded by the first S/D region height and the second S/D region height, or the first portion 310a of the boundary 330 may be outside of a plane perpendicular to the z-axis that extends through the first and second S/D regions 332a, 332b. In some embodiments, a contact 322 (e.g., a contact 322 over one of the S/D regions 332a, 332b or over the second gate material 212) may extend between a first contact height and a second contact height, and the second height 309b may be between the first contact height and the second contact height.

Although FIG. 3B illustrates one example rounded shape for the boundary 330, other rounded shapes are possible. For example, in some embodiments, the boundary 330 when viewed along a plane parallel to the z-direction may include a shape of a semi-circle, semi-ellipse, parabola, or rounded frustum of a polygon, such as a half of a rounded rectangle, a half of a rounded trapezoid, and so on, and the second isolation subregion 327b may have different shapes or widths. Furthermore, although FIG. 3B shows a certain height 329b for the second isolation subregion 327b, different heights are possible. FIGs. 3C and 3D show transistor assemblies with alternate backfilled isolation regions.

Although FIG. 3A, FIG. 3B, and other drawings herein show that channel materials (e.g., the first channel material 202 and the second channel material 206) may extend through masses of first and second S/D materials (e.g., the first channel material 202 through the first S/D material 204, and the second channel material 206 through the second S/D material 208), other configurations for the channel materials and the S/D materials are possible, and may be depicted differently. As an example, referring to FIG. 3A, the first S/D material 204 may be formed using an etching/deposition process. In such a process, portions of the first channel material 202 may be etched to form recesses at locations of future first S/D regions (e.g., regions of the first S/D material designated for the source and drain). An epitaxial deposition process may be used to fill the recesses with material used to fabricate first S/D regions (e.g., including the first S/D material 204). In some embodiments, the first S/D regions may be fabricated using silicon, or a silicon alloy such as silicon germanium or silicon carbide. In some implementations, an epitaxially deposited silicon or silicon alloy may be doped in situ, with dopants such as boron, arsenic, or phosphorous. In some embodiments, the first S/D regions may be formed using one or more alternate semiconductor materials such as germanium or a group III-IV material or alloy. In some embodiments, one or more layers of metal and/or metal alloys may be used to form the first S/D regions. As another example, referring to FIG. 3B, the second S/D material 208 may be formed in portions of the second channel material 206 by an etching/deposition process. Such an etching/deposition process may be similar to the etching/deposition process described above with reference to the first S/D material 204 and the first channel material 202.

In FIG. 3C, a transistor assembly 300c is illustrated. Parts of the transistor assembly 300c, such as the second channel material 206, the second S/D material 208, and so on, may be the same as presented in FIG. 3B, and are not described further here in detail. In contrast with FIG. 3B, a boundary 340 between first and second isolation subregions 337a, 337b of an isolation region 240c shown in FIG. 3C has a different shape when viewed along a plane parallel to the z-direction, i.e. a shape of half of a rounded rectangle. Additionally, a height 349b of the second isolation subregion 337b shown in FIG. 3C is less than the corresponding second height 329b of the second isolation subregion 327b shown in FIG. 3B (e.g., the height 339b shown in FIG. 3C is level with a less high portion of the first and second semiconductor regions, such as a lower nanoribbon of second channel material 206, than the corresponding height shown in FIG. 3B). Furthermore, as shown in FIG. 3C, the second isolation material 216 extends along the width 338 of the second end 336b of the isolation region 240c. In this example, no wall of first isolation material 214 is between the second isolation material 216 and dielectric material 106 adjacent to the S/D material 208. The first isolation material 214 may be removed along the width of the isolation region 240c during a process of removal of the first isolation material 214 (e.g., by an etching process) as described further below.

In FIG. 3D, a transistor assembly 300d is illustrated. Similarly to FIG. 3C, parts of the transistor assembly 300d, such as the second channel material 206, the second S/D material 208, and so on, may be the same as presented in FIG. 3B, and are not described further here in detail. In contrast with FIG. 3B, a boundary 350 between first and second isolation subregions 337a, 337b of an isolation region 240d shown in FIG. 3D has a different shape when viewed along a plane parallel to the z-direction, i.e. a shape of half of a rounded trapezoid. Additionally, a height 349b of the second isolation subregion 347b is greater than the corresponding second height 329b of the second isolation subregion 327b shown in FIG. 3B.

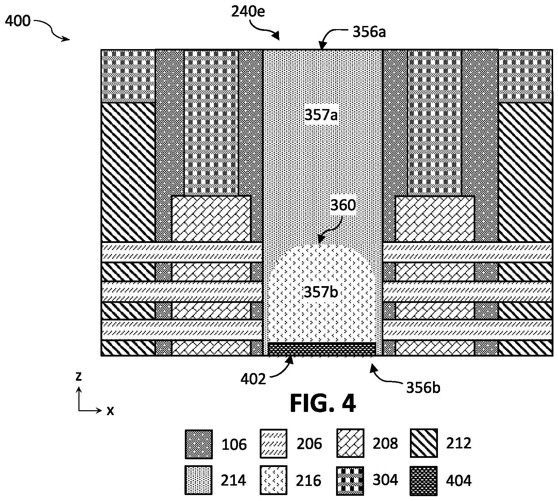

FIG. 4 is a cross-sectional view of a transistor assembly 400 with a cap 402 over a back side-filled air gap, according to some embodiments of the present disclosure. Parts of the transistor assembly 400, such as the second channel material 206, the second S/D material 208, and so on, may be the same as presented in FIG. 3B, and are not described further here in detail. An isolation region 240e of the transistor assembly 400 includes a first isolation subregion 357a with the first isolation material 214, and a second isolation subregion 357b with the second isolation material 216, where the second isolation material 216 in FIG. 4 includes air, with a boundary 360 (i.e., border) between the first and second isolation subregions 357a, 357b. In particular, the second isolation subregion 357b may be a back side-filled air gap. The back side-filled air gap can include a cap 402 that can be adjacent to an end 356b of the isolation region 240e (the end 356b at a bottom or back side of the isolation region 240e, the end 356b on an opposite side of the isolation region 240e from an end 356a at a top or front side of the isolation region 240e). The cap 402 can include a cap material 404. The cap material 404 may include, for example, silicon and oxygen. The cap material 404 may include additional or alternative materials, including any of the materials described with respect to the dielectric material 106. The cap 402 can seal the back side-filled air gap and prevent ingress of material into the back side-filled air gap, such as metal deposited during a back side metallization layer formation process, as described further later in this disclosure. Although the second isolation subregion 357b as described above may include a back side-filled air gap (which may be understood as a void or a cavity including air), in other embodiments, the second isolation may include a void or cavity that may include no material, or may include another material instead of or in addition to air, such as oxygen, nitrogen, helium, argon, or another gas.

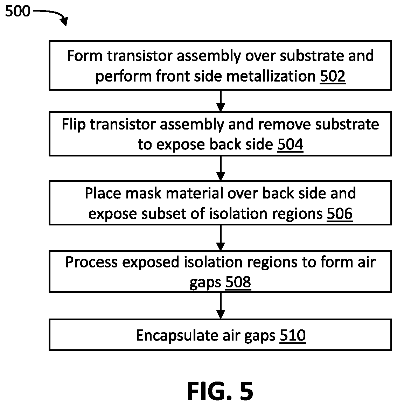

FIG. 5 illustrates one example process 500 that may be used to manufacture a transistor assembly with a back side-filled isolation region having an air gap, according to some embodiments of the present disclosure. FIGS. 6A-6F are side, cross-sectional views of various stages in the example process 500. Although the operations discussed below with reference to FIGS. 6A-6F (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 6A-6F may be modified in accordance with the present disclosure to fabricate others of transistor assemblies disclosed herein.

At 502 of FIG. 5, a transistor assembly is formed over a support structure, and front side metallization over the transistor assembly is performed. FIG. 6A shows an assembly including a portion of a transistor assembly 606 formed over a support structure 102 (a back side of the transistor assembly 606 facing the support structure 102), and a front side metallization structure 604 (i.e., front side metallization layers or front side interconnect layers) over the transistor assembly 606 (a front side of the transistor assembly 606 facing the front side metallization structure 604). A legend at the bottom of FIG. 6A illustrates that FIG. 6A uses different patterns to show a support structure 102, a dielectric material 106, a second channel material 206, a second S/D material 208, a second gate material 212, an isolation material 214, and a contact material 304. The support structure 102, the dielectric material 106, the second channel material 206, and so on, may be the same as described above with reference to other figures. The legend additionally includes a pattern for a front side metallization structure 604. As shown, FIG. 6A shows a portion of the transistor assembly 606, but other similar or identical transistors or other materials or structures (such as additional isolation regions including the isolation material 214, additional contact material joined to portions of the other transistors, and so on) are included in other portions of the transistor assembly 606 (for example, in other cross-sections of the transistor assembly 606 not shown).

The support structure 102 shown in FIG. 6A may be the same as or similar to the support structure 102 shown in FIG. 1. As illustrated, the transistor assembly 606 includes transistors with channel material 206 (e.g., in the form of nanoribbon channels), S/D material 208, and gate material 212. The method of forming the transistor assembly 606 over the support structure 102 is not limited, and any suitable technique for forming the transistor assembly 606 may be used. For example, the channel material 206 may be formed in the same manner as the channel material 104 described with respect to FIG. 1 above (e.g., nanoribbons of the channel material 206 can be formed by alternating layers of the channel material and a sacrificial material over the support structure 102, removing the sacrificial material from the stack of layers and replacing with another material, and so on). Various components of the transistor assembly 606 may be formed by conventional transistor formation techniques.

Contact material 304 is placed over the S/D material 208 and the gate material 212, the contact material 304 extending away from the S/D material 208 and gate material 212 and substantially along the z-axis towards the top or front side of the transistor assembly 606. Additionally, in FIG. 6A, an isolation region 608 including the isolation material 214 is shown, which can be placed between transistors (e.g., transistors of the transistor assembly 606 shown at the left and right sides of FIG. 6A). Dielectric material 106 is deposited in gaps of the transistor assembly 606 (e.g., between the S/D material 208 and the first isolation material 214, between the S/D material 208 and the gate material 212, etc.).

A front side metallization structure 604 can be formed over the transistor assembly 606, and the contact material 304 can be joined to conductive features in the front side metallization structure 604. The front side metallization structure 604 can include electrically conductive trenches (not shown), also referred to as lines, which provide connectivity across the layer, and electrically conductive vias (or, simply, "vias") (not shown) that provide electrical connectivity between different layers. In general, the term "trench" or "line" may be used to describe an electrically conductive element isolated by an insulator material (e.g., an insulator material typically comprising a low-k dielectric) that is provided in a plane parallel to the plane of an IC die/chip or a support structure (e.g., the support structure 102) over which an IC structure is provided, while the term "via" may be used to describe an electrically conductive element that interconnects two or more trenches of different levels of a metallization stack, or a component of the transistor layer and one or more trenches of a metallization layer. To that end, a via may be provided substantially perpendicularly to the plane of an IC die/chip or support structure over which an IC structure is provided, and the via may interconnect two trenches in adjacent levels, two trenches in not adjacent levels, and/or a component of a transistor layer and a trench in adjacent or not adjacent layers. Sometimes, trenches and vias may be referred to as "metal trenches/tracks/lines/traces" and "metal vias", respectively, to highlight the fact that these elements include electrically conductive materials such as, but not limited to, metals. Together, trenches and vias may be referred to as "interconnects," where the term "interconnect" may be used to describe any element formed of an electrically conductive material for providing electrical connectivity to/from one or more components associated with an IC or/and between various such components.

At 504 of FIG. 5, the transistor assembly is flipped (e.g., upside-down), and the support structure is removed, exposing the back side of the transistor assembly. FIG. 6B shows the transistor assembly 606 of FIG. 6A flipped in orientation (e.g., such that the contact material 304 extends away from the S/D material 208 and gate material 212 substantially along the z-axis towards a bottom of the transistor assembly 606, and such that the front side metallization structure 604 is present at the bottom of the transistor assembly 606). A legend at the bottom of FIG. 6B illustrates that FIG. 6B uses similar patterns to the patterns used in FIG. 6A, but omits the pattern for the support structure 102, which has been removed from a back side of the transistor assembly 606 (facing upwards in FIG. 6B). The support structure 102 may be removed by any suitable technique. For example, the support structure 102 may be separated (e.g., peeled, debonded, or delaminated) from the transistor assembly 606 using a tool (such as a blade, an adhesive pad, a roller, a suction tool, or another tool) to force apart the support structure 102 and the transistor assembly 606. After separation, exposed surfaces of the transistor assembly 606 (i.e., along the upwardly facing back side of the transistor assembly 606) may be cleaned, polished, and/or planarized using a conventional cleaning, polishing, or planarization method such as chemical-mechanical polishing (CMP).

At 506 of FIG. 5, the back side of the transistor assembly is masked, and a subset of the isolation regions of the transistor assembly is exposed. FIG. 6C shows the assembly of FIG. 6B, which includes one isolation region 608 in the subset of isolation regions. FIG. 6C shows the portion of the transistor assembly 606 after placement of a mask material 610 (e.g., a lithography mask) and after removal of a portion of the mask material 610 to expose an end 608a of the isolation region 608. A legend at the bottom of FIG. 6C illustrates that FIG. 6C uses similar patterns to the patterns used in FIG. 6B, but includes the pattern for the mask material 610. Placement and removal of the mask material 610 may be conducted using any suitable technique (for example, conventional lithography techniques). Although FIG. 6C shows that a portion of the remaining mask material 610 covers a portion of the end 608a of the isolation region 608, in some embodiments, the portion of the remaining mask material 610 may not be over the end 608a of the isolation region 608.

At 508 of FIG. 5, the exposed isolation regions are processed to form air gaps. FIG. 6D shows the assembly of FIG. 6C after a process of forming an air gap 609 in the exposed isolation region 608 (e.g., forming a back side-filled isolation region with an air gap, the formation through a gap in the mask material 610, from the end 608a). The air gap 609 may be formed using any conventional technique. For example, the air gap 609 may be formed using an etching process. As shown, a boundary 611 with a curved portion is formed between the air gap 609 and a remaining portion of the isolation material 214. The curved portion of the boundary in FIG. 6D is substantially curved towards the front side metallization structure 604 (along the bottom of the transistor assembly 606).

At 510 of FIG. 5, the air gaps are encapsulated. FIG. 6E shows the assembly of FIG. 6D after placing a cap material 612 (e.g., a dielectric material) over the mask material 610 and over the air gap 609. Part of the cap material 612 fills part of the air gap 609 such that the cap material 612 is adjacent to part of the isolation material 214. FIG. 6F shows the assembly of FIG. 6E after removing a portion of the cap material 612 and the mask material 610 from the back side of the transistor assembly 606, leaving behind a portion of the cap material 612 inside the isolation region 608 and adjacent to a part of the isolation material 214. The remaining portion of the cap material 612 encloses the air gap 609 in the isolation region 608. After the process 500, further processing of the transistor assembly 606 may be performed, such as formation of a back side metallization layer (not shown) over the back side of the transistor assembly 606.

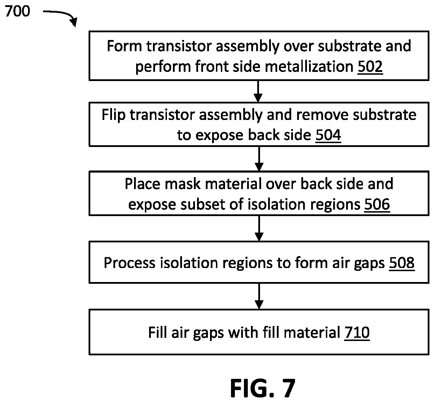

FIG. 7 illustrates one example process 700 that may be used to manufacture a transistor assembly with a back side-filled isolation region having a fill material, according to some embodiments of the present disclosure. The process 700 includes parts 502, 504, 506, and 508, which are the same as the corresponding parts 502, 504, 506, 508 of FIG. 5, and the corresponding figures FIG. 6A-6D described above in reference to FIG. 5 may similarly apply to parts 502, 504, 506, 508 of FIG. 7. Although the operations discussed below with reference to FIGS. 8A-8B (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 8A-8B may be modified in accordance with the present disclosure to fabricate others of transistor assemblies disclosed herein.

At 710 of FIG. 7, air gaps are filled with a fill material. FIG. 8A shows the assembly of FIG. 6D after placing a fill material 810 over the back side of the transistor assembly 606. The fill material 810 (e.g., a second isolation material, which may be the same as the second isolation material described above with reference to any one of the preceding figures including the second isolation material 216) is deposited over the mask material 610 and in the air gap 609 in the isolation region 608. FIG. 8B shows the portion of the transistor assembly 606 of FIG. 8A after removing a portion of the fill material 810 such that only the portion of the fill material 810 in the isolation region 608 remains. The mask material 610 is also removed. As shown, a boundary 621 with a curved portion is formed between the fill material 810 and a remaining portion of the isolation material 214. The curved portion of the boundary 621 in FIG. 8B is substantially curved towards the front side metallization structure 604 along the bottom of the transistor assembly 606. After the process 700, further processing of the transistor assembly 606 may be performed, such as formation of a back side metallization layer (not shown) over the back side of the transistor assembly 606.

The IC devices (with transistor assemblies with back side-filled isolation regions), electronic devices (e.g., with device layers having transistor assemblies with back side-filled isolation regions), or transistor assemblies (e.g., with back side-filled isolation regions) disclosed herein may be included in any suitable apparatus. FIGS. 9-12 illustrate various examples of apparatuses that may include one or more of the IC devices, electronic devices, or transistor assemblies disclosed herein (collectively referred to as electronic assemblies), which may have been fabricated using the processes disclosed herein.

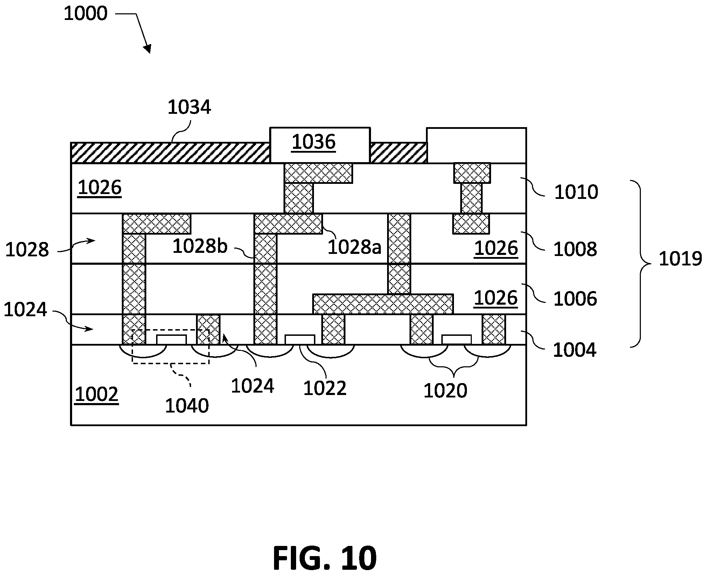

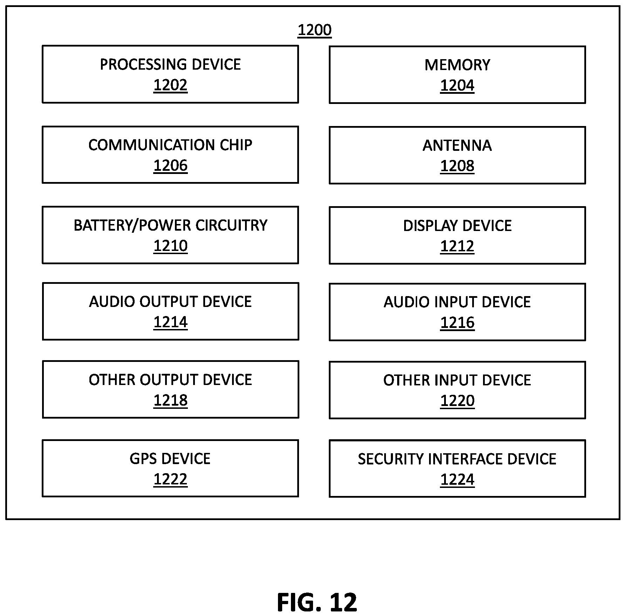

FIG. 9A and 9B are top views of a wafer and dies that include one or more IC structures including one or more electronic assemblies in accordance with any of the embodiments disclosed herein. The wafer 900 may be composed of semiconductor material and may include one or more dies 902 having IC structures formed on a surface of the wafer 900. Each of the dies 902 may be a repeating unit of a semiconductor product that includes any suitable IC structure or electronic assembly (e.g., IC structures or electronic assemblies as shown in or described with reference to any of FIGS. 1-8, or any further embodiments of the IC structures or electronic assemblies described herein). After the fabrication of the semiconductor product is complete (e.g., after manufacture of one or more IC structures or electronic assemblies as described herein, included in a particular electronic component, e.g., in a transistor device or in a memory device), the wafer 900 may undergo a singulation process in which each of the dies 902 is separated from one another to provide discrete "chips" of the semiconductor product. In particular, devices that include one or more of the IC structures or electronic assemblies as disclosed herein may take the form of the wafer 900 (e.g., not singulated) or the form of the die 902 (e.g., singulated). The die 902 may include one or more transistors (e.g., one or more of the transistors 1040 of FIG. 10, discussed below) and/or supporting circuitry to route electrical signals to the transistors, as well as any other IC components (e.g., one or more of the transistors described herein). In some embodiments, the wafer 900 or the die 902 may include a memory device (e.g., a static random access memory or SRAM device), a logic device (e.g., an AND, OR, NAND, or NOR gate), or any other suitable circuit element. Multiple ones of these devices may be combined on a single die 902. For example, a memory array formed by multiple memory devices may be formed on a same die 902 as a processing device (e.g., the processing device 1202 of FIG. 12) or other logic that is configured to store information in the memory devices or execute instructions stored in the memory array.

FIG. 10 is a cross-sectional side view of an IC device 1000 that may include one or more electronic assemblies in accordance with any of the embodiments disclosed herein. The IC device 1000 may be formed on a substrate 1002 (e.g., the wafer 900 of FIG. 9A) and may be included in a die (e.g., the die 902 of FIG. 9B). The substrate 1002 may be any substrate as described herein. The substrate 1002 may be part of a singulated die (e.g., the dies 902 of FIG. 9B) or a wafer (e.g., the wafer 900 of FIG. 9A).

The IC device 1000 may include one or more device layers 1004 disposed on the substrate 1002. The device layer 1004 may include features of one or more transistors 1040 (e.g., metal-oxide-semiconductor field effect transistors (MOSFETs)) formed on the substrate 1002. The device layer 1004 may include, for example, one or more source and/or drain (S/D) regions 1020, a gate 1022 to control current flow in the transistors 1040 between the S/D regions 1020, and one or more S/D contacts 1024 to route electrical signals to/from the S/D regions 1020. The transistors 1040 may include additional features not depicted for the sake of clarity, such as device isolation regions, gate contacts, and the like. The transistors 1040 are not limited to the type and configuration depicted in FIG. 10 and may include a wide variety of other types and configurations such as, for example, planar transistors, non-planar transistors, or a combination of both. Non-planar transistors may include fin-type field effect transistors (FinFETs), such as double-gate transistors or tri-gate transistors, and wrap-around or all-around gate transistors, such as nanoribbon and nanowire transistors.

Each transistor 1040 may include a gate 1022 formed of at least two layers, a gate electrode layer and a gate dielectric layer. The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer may enable the formation of a PMOS gate electrode with a workfunction that is between about 4.9 electron Volts (eV) and about 5.2 eV, for example. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer may enable the formation of an NMOS gate electrode with a workfunction that is between about 3.9 eV and about 4.2 eV, for example.

In some embodiments, when viewed as a cross-section of the transistor 1040 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1040 may include one layer or a stack of layers, and the one or more layers may include silicon oxide, silicon dioxide, and/or a high-k dielectric material. The high-k dielectric material included in the gate dielectric layer of the transistor 1040 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1000 may include one or more transistor layers with back side-filled isolation regions, or another electronic assembly, in accordance with any of the embodiments disclosed herein, at any suitable location in the IC device 1000.

The S/D regions 1020 may be formed within the substrate 1002 adjacent to the gate 1022 of each transistor 1040, using any suitable processes known in the art. For example, the S/D regions 1020 may be formed using either an implantation/diffusion process or a deposition process. In the former process, dopants such as boron, aluminum, antimony, phosphorous, or arsenic may be ion-implanted into the substrate 1002 to form the S/D regions 1020. An annealing process that activates the dopants and causes them to diffuse farther into the substrate 1002 may follow the ion implantation process. In the latter process, an epitaxial deposition process may provide material that is used to fabricate the S/D regions 1020. In some implementations, the S/D regions 1020 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1020 may be formed using one or more alternate semiconductor materials such as germanium or a group III-V material or alloy. In further embodiments, one or more layers of metal and/or metal alloys may be used to form the S/D regions 1020. In some embodiments, an etch process may be performed before the epitaxial deposition to create recesses in the substrate 1002 in which the material for the S/D regions 1020 is deposited.

Electrical signals, such as power and/or input/output (I/O) signals, may be routed to and/or from the transistors 1040 of the device layer 1004 through one or more interconnect layers disposed on the device layer 1004 (illustrated in FIG. 10 as interconnect layers 1006-1010). For example, electrically conductive features of the device layer 1004 (e.g., the gate 1022 and the S/D contacts 1024) may be electrically coupled with the interconnect structures 1028 of the interconnect layers 1006-1010. The one or more interconnect layers 1006-1010 may form an ILD stack 1019 of the IC device 1000.

The interconnect structures 1028 may be arranged within the interconnect layers 1006-1010 to route electrical signals according to a wide variety of designs (in particular, the arrangement is not limited to the particular configuration of interconnect structures 1028 depicted in FIG. 10). Although a particular number of interconnect layers 1006-1010 is depicted in FIG. 10 embodiments of the present disclosure include IC devices having more or fewer interconnect layers than depicted.

In some embodiments, the interconnect structures 1028 may include trench contact structures 1028a (sometimes referred to as "lines") and/or via structures 1028b (sometimes referred to as "holes") filled with an electrically conductive material such as a metal. The trench contact structures 1028a may be arranged to route electrical signals in a direction of a plane that is substantially parallel with a surface of the substrate 1002 upon which the device layer 1004 is formed. For example, the trench contact structures 1028a may route electrical signals in a direction in and out of the page from the perspective of FIG. 10. The via structures 1028b may be arranged to route electrical signals in a direction of a plane that is substantially perpendicular to the surface of the substrate 1002 upon which the device layer 1004 is formed. In some embodiments, the via structures 1028b may electrically couple trench contact structures 1028a of different interconnect layers 1006-1010 together.

The interconnect layers 1006-1010 may include a dielectric material 1026 disposed between the interconnect structures 1028, as shown in FIG. 10. The dielectric material 1026 may take the form of any of the embodiments of the dielectric material provided between the interconnects of the IC structures disclosed herein.

In some embodiments, the dielectric material 1026 disposed between the interconnect structures 1028 in different ones of the interconnect layers 1006-1010 may have different compositions. In other embodiments, the composition of the dielectric material 1026 between different interconnect layers 1006-1010 may be the same.

A first interconnect layer 1006 (referred to as metal 1 or "M1") may be formed directly on the device layer 1004. In some embodiments, the first interconnect layer 1006 may include trench contact structures 1028a and/or via structures 1028b, as shown. The trench contact structures 1028a of the first interconnect layer 1006 may be coupled with contacts (e.g., the S/D contacts 1024) of the device layer 1004.

A second interconnect layer 1008 (referred to as metal 2 or "M2") may be formed directly on the first interconnect layer 1006. In some embodiments, the second interconnect layer 1008 may include via structures 1028b to couple the trench contact structures 1028a of the second interconnect layer 1008 with the trench contact structures 1028a of the first interconnect layer 1006. Although the trench contact structures 1028a and the via structures 1028b are structurally delineated with a line within each interconnect layer (e.g., within the second interconnect layer 1008) for the sake of clarity, the trench contact structures 1028a and the via structures 1028b may be structurally and/or materially contiguous (e.g., simultaneously filled during a dual-damascene process) in some embodiments.

A third interconnect layer 1010 (referred to as metal 3 or "M3") (and additional interconnect layers, as desired) may be formed in succession on the second interconnect layer 1008 according to similar techniques and configurations described in connection with the second interconnect layer 1008 or the first interconnect layer 1006.

The IC device 1000 may include a solder resist material 1034 (e.g., polyimide or similar material) and one or more bond pads 1036 formed on the interconnect layers 1006-1010. The bond pads 1036 may be electrically coupled with the interconnect structures 1028 and configured to route the electrical signals of the transistor(s) 1040 to other external devices. For example, solder bonds may be formed on the one or more bond pads 1036 to mechanically and/or electrically couple a chip including the IC device 1000 with another component (e.g., a circuit board). The IC device 1000 may have other alternative configurations to route the electrical signals from the interconnect layers 1006-1010 than depicted in other embodiments. For example, the bond pads 1036 may be replaced by or may further include other analogous features (e.g., posts) that route the electrical signals to external components.

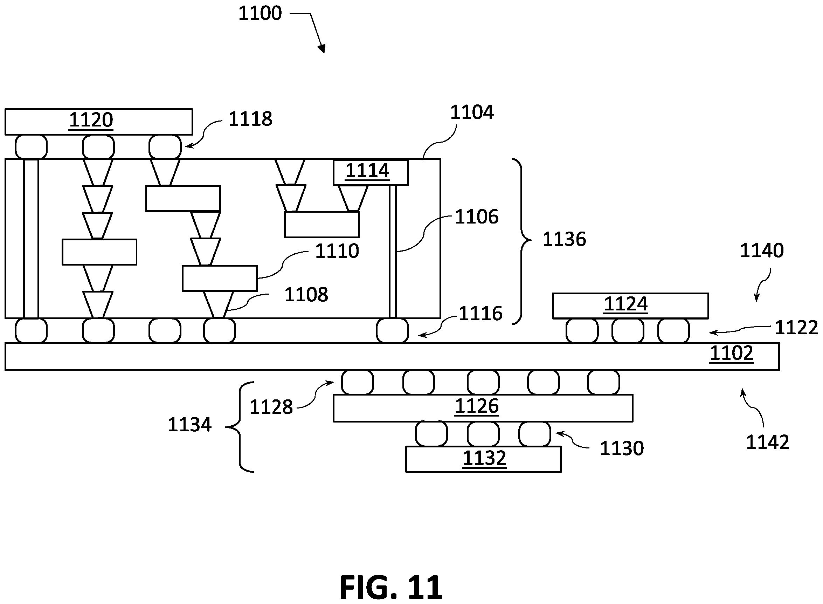

FIG. 11 is a cross-sectional side view of an IC device assembly 1100 that may include components having or being associated with (e.g., being electrically connected by means of) one or more transistor layers with back side-filled isolation regions, or another electronic assembly, in accordance with any of the embodiments disclosed herein. The IC device assembly 1100 includes a number of components disposed on a circuit board 1102 (which may be, e.g., a motherboard). The IC device assembly 1100 includes components disposed on a first face 1140 of the circuit board 1102 and an opposing second face 1142 of the circuit board 1102; generally, components may be disposed on one or both faces 1140 and 1142. In particular, any suitable ones of the components of the IC device assembly 1100 may include one or more of the non-planar transistors disclosed herein.

In some embodiments, the circuit board 1102 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1102. In other embodiments, the circuit board 1102 may be a non-PCB substrate.

The IC device assembly 1100 illustrated in FIG. 11 includes a package-on-interposer structure 1136 coupled to the first face 1140 of the circuit board 1102 by coupling components 1116. The coupling components 1116 may electrically and mechanically couple the package-on-interposer structure 1136 to the circuit board 1102 and may include solder balls (as shown in FIG. 11), male and female portions of a socket, an adhesive, an underfill material, and/or any other suitable electrical and/or mechanical coupling structure.

The package-on-interposer structure 1136 may include an IC package 1120 coupled to an interposer 1104 by coupling components 1118. The coupling components 1118 may take any suitable form for the application, such as the forms discussed above with reference to the coupling components 1116. Although a single IC package 1120 is shown in FIG. 11, multiple IC packages may be coupled to the interposer 1104; indeed, additional interposers may be coupled to the interposer 1104. The interposer 1104 may provide an intervening substrate used to bridge the circuit board 1102 and the IC package 1120. The IC package 1120 may be or include, for example, a die (the die 902 of FIG. 9B), an IC device (e.g., the IC device 1000 of FIG. 10), or any other suitable component. In some embodiments, the IC package 1120 may include one or more transistor layers with back side-filled isolation regions, or another electronic assembly, as described herein. Generally, the interposer 1104 may spread a connection to a wider pitch or reroute a connection to a different connection. For example, the interposer 1104 may couple the IC package 1120 (e.g., a die) to a ball grid array (BGA) of the coupling components 1116 for coupling to the circuit board 1102. In the embodiment illustrated in FIG. 11, the IC package 1120 and the circuit board 1102 are attached to opposing sides of the interposer 1104; in other embodiments, the IC package 1120 and the circuit board 1102 may be attached to a same side of the interposer 1104. In some embodiments, three or more components may be interconnected by way of the interposer 1104.

The interposer 1104 may be formed of an epoxy resin, a fiberglass-reinforced epoxy resin, a ceramic material, or a polymer material such as polyimide. In some implementations, the interposer 1104 may be formed of alternate rigid or flexible materials that may include the same materials described above for use in a semiconductor substrate, such as silicon, germanium, and other group III-V and group IV materials. The interposer 1104 may include metal interconnects 1108 and vias 1110, including but not limited to TSVs 1106. The interposer 1104 may further include embedded devices 1114, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1104. The package-on-interposer structure 1136 may take the form of any of the package-on-interposer structures known in the art.

The IC device assembly 1100 may include an IC package 1124 coupled to the first face 1140 of the circuit board 1102 by coupling components 1122. The coupling components 1122 may take the form of any of the embodiments discussed above with reference to the coupling components 1116, and the IC package 1124 may take the form of any of the embodiments discussed above with reference to the IC package 1120.

The IC device assembly 1100 illustrated in FIG. 11 includes a package-on-package structure 1134 coupled to the second face 1142 of the circuit board 1102 by coupling components 1128. The package-on-package structure 1134 may include an IC package 1126 and an IC package 1132 coupled together by coupling components 1130 such that the IC package 1126 is disposed between the circuit board 1102 and the IC package 1132. The coupling components 1128 and 1130 may take the form of any of the embodiments of the coupling components 1116 discussed above, and the IC packages 1126 and 1132 may take the form of any of the embodiments of the IC package 1120 discussed above. The package-on-package structure 1134 may be configured in accordance with any of the package-on-package structures known in the art.

FIG. 12 is a block diagram of an example computing device 1200 that may include one or more one or more transistor layers with back side-filled isolation regions, or another electronic assembly, in accordance with any of the embodiments disclosed herein. For example, any suitable ones of the components of the computing device 1200 may include a die (e.g., the die 902 of FIG. 9B) having one or more transistor layers with back side-filled isolation regions, or another electronic assembly. Any one or more of the components of the computing device 1200 may include, or be included in, an IC device (e.g., the IC device 1000 of FIG. 12). Any one or more of the components of the computing device 1200 may include, or be included in, an IC device assembly (e.g., the IC device assembly 1100 of FIG. 11).

A number of components are illustrated in FIG. 12 as included in the computing device 1200, but any one or more of these components may be omitted or duplicated, as suitable for the application. In some embodiments, some or all of the components included in the computing device 1200 may be attached to one or more motherboards. In some embodiments, some or all of these components are fabricated onto a single system-on-a-chip (SoC) die.

Additionally, in various embodiments, the computing device 1200 may not include one or more of the components illustrated in FIG. 12, but the computing device 1200 may include interface circuitry for coupling to the one or more components. For example, the computing device 1200 may not include a display device 1212, but may include display device interface circuitry (e.g., a connector and driver circuitry) to which a display device 1212 may be coupled. In another set of examples, the computing device 1200 may not include an audio input device 1216 or an audio output device 1214, but may include audio input or output device interface circuitry (e.g., connectors and supporting circuitry) to which an audio input device 1216 or audio output device 1214 may be coupled.

The computing device 1200 may include a processing device 1202 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1202 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1200 may include a memory 1204, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1204 may include memory that shares a die with the processing device 1202. This memory may be used as cache memory and may include embedded dynamic random access memory (eDRAM) or spin transfer torque magnetic random access memory (STT-MRAM).

In some embodiments, the computing device 1200 may include a communication chip 1206 (e.g., one or more communication chips). For example, the communication chip 1206 may be configured for managing wireless communications for the transfer of data to and from the computing device 1200. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1206 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1206 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1206 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1206 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1206 may operate in accordance with other wireless protocols in other embodiments. The computing device 1200 may include an antenna 1208 to facilitate wireless communications and/or to receive other wireless communications (such as AM or FM radio transmissions).

In some embodiments, the communication chip 1206 may manage wired communications, such as electrical, optical, or any other suitable communication protocols (e.g., the Ethernet). As noted above, the communication chip 1206 may include multiple communication chips. For instance, a first communication chip 1206 may be dedicated to shorter-range wireless communications such as Wi-Fi or Bluetooth, and a second communication chip 1206 may be dedicated to longer-range wireless communications such as global positioning system (GPS), EDGE, GPRS, CDMA, WiMAX, LTE, EV-DO, or others. In some embodiments, a first communication chip 1206 may be dedicated to wireless communications, and a second communication chip 1206 may be dedicated to wired communications.

The computing device 1200 may include a battery/power circuitry 1210. The battery/power circuitry 1210 may include one or more energy storage devices (e.g., batteries or capacitors) and/or circuitry for coupling components of the computing device 1200 to an energy source separate from the computing device 1200 (e.g., AC line power).

The computing device 1200 may include a display device 1212 (or corresponding interface circuitry, as discussed above). The display device 1212 may include any visual indicators, such as a heads-up display, a computer monitor, a projector, a touchscreen display, a liquid crystal display (LCD), a light-emitting diode display, or a flat panel display, for example.

The computing device 1200 may include an audio output device 1214 (or corresponding interface circuitry, as discussed above). The audio output device 1214 may include any device that generates an audible indicator, such as speakers, headsets, or earbuds, for example.

The computing device 1200 may include an audio input device 1216 (or corresponding interface circuitry, as discussed above). The audio input device 1216 may include any device that generates a signal representative of a sound, such as microphones, microphone arrays, or digital instruments (e.g., instruments having a musical instrument digital interface (MIDI) output).

The computing device 1200 may include another output device 1218 (or corresponding interface circuitry, as discussed above). Examples of the other output device 1218 may include an audio codec, a video codec, a printer, a wired or wireless transmitter for providing information to other devices, or an additional storage device.

The computing device 1200 may include another input device 1220 (or corresponding interface circuitry, as discussed above). Examples of the other input device 1220 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1200 may include a GPS device 1222 (or corresponding interface circuitry, as discussed above). The GPS device 1222 may be in communication with a satellite-based system and may receive a location of the computing device 1200, as known in the art.

The computing device 1200 may include a security interface device 1224. The security interface device 1224 may include any device that provides security features for the computing device 1200 or for any individual components therein (e.g., for the processing device 1202 or for the memory 1204). Examples of security features may include authorization, access to digital certificates, access to items in keychains, etc. Examples of the security interface device 1224 may include a software firewall, a hardware firewall, an antivirus, a content filtering device, or an intrusion detection device.

The computing device 1200 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1200 may be any other electronic device that processes data.

The following paragraphs provide various examples of the embodiments disclosed herein.

Example 1 provides a device (e.g., an electronic device or an integrated circuit (IC) device) including a first semiconductor region; a second semiconductor region; a contact coupled to the first semiconductor region, the contact extending away from the first semiconductor region in a direction; and an isolation region adjacent to the first semiconductor region and adjacent to the second semiconductor region, the isolation region including a first isolation subregion; and a second isolation subregion, where a boundary between the first isolation subregion and the second isolation subregion includes a curved shape that is substantially curved towards the direction (or, curved in the direction).

Example 2 provides the device of example 1, where the boundary includes a shape of a semi-circle, semi-ellipse, parabola, or rounded frustum of a polygon along a plane parallel to the direction.

Example 3 provides the device of examples 1 or 2, where the first isolation subregion includes a first isolation material, and the second isolation subregion includes a second isolation material different from the first isolation material.

Example 4 provides the device of example 3, where the first isolation material has a greater density than the second isolation material.

Example 5 provides the device of any one of examples 1-4, where the first isolation subregion exerts a first force on the first and second semiconductor regions, and the second isolation subregion exerts a second force on the first and second semiconductor regions, the first force different from the second force.

Example 6 provides the device of any one of examples 1-5, where the second isolation subregion includes a cavity, a void, or an air gap.

Example 7 provides the device of any one of examples 1-6, further including a dielectric cap over an end of the second isolation subregion, the end on an opposite side of the second isolation subregion from the boundary.

Example 8 provides the device of any one of examples 1-7, where the first semiconductor region and/or the second semiconductor region includes a fin-shaped channel region, a nanoribbon, a forksheet, or a nanowire.

Example 9 provides the device of any one of examples 1-8, where at least a portion of the first isolation subregion is between the first semiconductor region and the second isolation subregion.

Example 10 provides the device of any one of examples 1-9, where the isolation region is adjacent to a gate line.

Example 11 provides the device of any one of examples 1-10, where a plane tangent to a portion of the boundary is substantially perpendicular to the direction, the plane extending through the first and second semiconductor regions.

Example 12 provides the device of any one of examples 1-11, where the first semiconductor region extends between a first length in the direction and a second length in the direction, the curved shape of the boundary extends to a third length in the direction, and the third length is between the first and second lengths.

Example 13 provides the device of any one of examples 1-11, where the contact extends between a first length in the direction and a second length in the direction, the curved shape of the boundary extends to a third length in the direction, and the third length is between the first and second lengths.

Example 14 provides the device of any one of examples 1-11, where the first semiconductor region extends between a first length in the direction and a second length in the direction, the curved shape of the boundary extends to a third length in the direction, and the third length is outside of a range bounded by the second and third lengths.

Example 15 provides the device of any one of examples 1-11, where the boundary is outside of a plane perpendicular to the direction, the plane extending through the first and second semiconductor regions.

Example 16 provides the device of any one of examples 1-15, where the isolation region is a first isolation region, and the device further includes a third semiconductor region; a fourth semiconductor region; and a second isolation region adjacent to the third semiconductor region and adjacent to the fourth semiconductor region, the second isolation region having an end substantially opposed to the direction, the end having a width, where the second isolation region includes a second isolation region material that extends along the width.

Example 17 provides a device (e.g., an electronic device or an integrated circuit (IC) device), including a first source or drain (S/D) region in a device layer; a second S/D region in the device layer; a back side metallization layer below the device layer; an isolation region between the first and second S/D regions, the isolation region including a first isolation material extending to a first height over the back side metallization layer; and a second isolation material extending to a second height over the back side metallization layer, the second height less than the first height, where a border between first isolation material and the second isolation material has a first portion and a second portion, the first portion extending further from the back side metallization layer than the second portion.

Example 18 provides the device of any example 17 where the second isolation material includes air, a cavity, or a void.

Example 19 provides the device of examples 17 or 18, where the first isolation material exerts a first stress on the first and second S/D regions, and the second isolation material exerts a second stress on the first and second S/D regions, the first stress different from the second stress.

Example 20 provides the device of any one of examples 17-19, where the isolation region is a first isolation region, and the device further includes a third S/D region; a fourth S/D region; and a second isolation region between the third and fourth S/D regions, the second isolation region including the first isolation material. The second isolation region has an end closest to the back side metallization layer, the end has a width, and the first isolation material extends along the width.

Example 21 provides an assembly (e.g., a transistor assembly), including a first transistor including a first dopant; a second transistor including the first dopant; a third transistor including a second dopant; a fourth transistor including the second dopant; a first isolation region between the first and second transistors, the first isolation region including a first isolation material and a second isolation material, where a boundary between the first isolation material and the second isolation material has a substantially rounded shape; and a second isolation region between the third and fourth transistors, the second isolation region including the first isolation material.

Example 22 provides the assembly of example 21, further including a contact coupled to a portion of the first transistor, the contact extending away from the first transistor in a direction, where the boundary has a shape that is substantially rounded towards the direction.

Example 23 provides the assembly of example 22, where the second isolation region has an end substantially opposed to the direction, the end having a width, where a mass of the first isolation material extends along the width.

Example 24 provides the assembly of any one of examples 21-23, where the second isolation material includes air.

Example 25 provides the assembly of any one of examples 21-24, where the first isolation material exerts a first stress on at least portions of the first and second transistors, and the second isolation material exerts a second stress on at least portions of the first and second transistors, the first stress different from the second stress.

Example 26 provides the assembly of any one of examples 21-25, where the first isolation region exerts a first force on at least portions of the first and second transistors, and the second isolation region exerts a second force on at least portions of the third and fourth transistors, the first force different from the second force.

Example 27 provides the assembly of any one of examples 21-26, where a gate line of the first transistor is adjacent to the second isolation region.

## Claims

1. A device comprising:
a first semiconductor region;
a second semiconductor region;
a contact coupled to the first semiconductor region, the contact extending away from the first semiconductor region in a direction; and
an isolation region adjacent to the first semiconductor region and adjacent to the second semiconductor region, the isolation region comprising:
a first isolation subregion; and
a second isolation subregion, wherein a boundary between the first isolation subregion and the second isolation subregion includes a curved shape that is substantially curved towards the direction.

2. The device of claim 1, wherein the boundary includes a shape of a semi-circle, semi-ellipse, parabola, or rounded frustum of a polygon along a plane parallel to the direction.

3. The device of claim 1 or 2, wherein the first isolation subregion includes a first isolation material, and the second isolation subregion includes a second isolation material different from the first isolation material.

4. The device of claim 3, wherein the first isolation material has a greater density than the second isolation material.

5. The device of claim 3 or 4, wherein the second isolation material is air.

6. The device of any preceding claim, wherein the second isolation subregion includes a cavity.

7. The device of any preceding claim, further comprising a dielectric cap over an end of the second isolation subregion, the end on an opposite side of the second isolation subregion from the boundary.

8. The device of any preceding claim, wherein at least a portion of the first isolation subregion is between the first semiconductor region and the second isolation subregion.

9. The device of any preceding claim, wherein the isolation region is adjacent to a gate line.

10. The device of any preceding claim, wherein a plane tangent to a portion of the boundary is substantially perpendicular to the direction, the plane extending through the first and second semiconductor regions.

11. The device of any preceding claim, wherein the first semiconductor region extends between a first length in the direction and a second length in the direction, the curved shape of the boundary extends to a third length in the direction, and the third length is between the first and second lengths.

12. The device of any one of claims 1-10, wherein the contact extends between a first length in the direction and a second length in the direction, the curved shape of the boundary extends to a third length in the direction, and the third length is between the first and second lengths.

13. The device of any preceding claim, wherein the isolation region is a first isolation region, and the device further comprises:
a third semiconductor region;
a fourth semiconductor region; and
a second isolation region adjacent to the third semiconductor region and adjacent to the fourth semiconductor region, the second isolation region having an end substantially opposed to the direction, the end having a width, wherein the second isolation region includes a second isolation region material that extends along the width.

14. The device of any preceding claim, wherein the first semiconductor region is a first source or drain region, and the second semiconductor region is a second source or drain region.

15. A semiconductor package comprising a device according to any of claims 1-14, wherein the device is a die coupled to another component.
